# EUROPEAN PATENT APPLICATION

(11) **EP 1 786 108 A1**
(43) Date of publication of application: **16.05.2007**
(21) Application number: 06018048.6
(22) Date of filing: 29.08.2006
(51) Int. Cl.: H03M 7/30

(54) **Method and system for transmitting data to vehicles over limited data links**

(30) Priority: 09.11.2005 US 271447
(71) Applicant: HONDA MOTOR CO., Ltd., Tokyo 107-8556 (JP)
(72) Inventor: Nelson, Scott David, Redondo Beach, CA 90277 (US)
(74) Representative: Rupp, Christian

(57) **Abstract**

Methods and system are provided for communicating messages over limited bandwidth data links. The method generally comprises taking a message that comprises message objects, and converting the message into a protocol stream by identifying message objects having corresponding translations in the dictionary. In one approach, the method comprises converting each identified message object into a message token, and associating each non-identified message object with a free symbol indicator (232) to generate a free symbol segment. The message tokens and the free symbol segments are then concatenated to generate a protocol stream that is sent over the limited bandwidth data link.

## Description

### BACKGROUND OF THE INVENTION

### 1. Field of the Invention

The present invention relates to a method and system for transferring data over a limited data link between a transmitter and a receiver. More specifically, the present invention relates to a communication system for exchanging data between an onboard device and a remote center, wherein the onboard device and remote center each have copies of one or more dictionaries.

### 2. Description of Related Art

Limited-bandwidth and small-packet wireless data networks provide cost-effective, ubiquitous coverage and access to mobile applications, such as those present in vehicles. Such data networks, sometimes referred to as limited data links, make it possible to efficiently convey tens of bytes to a few hundred bytes of information, but put practical limits on the amount and richness of data that can be transferred and the applications that rely upon the data. Problems associated with limited data links include the fact that only a small number of bytes can be transmitted at a time, combined with the fact that the bit transfer rate can be slow. The high cost of data transfer puts practical limits on the volume of data that can be transmitted over the limited data links.

For example, if there is a 200 byte limit for user data (disregarding lower-level protocol information), 200 bytes is enough to transmit 228 English language clear-text characters, if those characters are encoded in 7-bit ASCII. This may be sufficient for a short text message consisting of a few sentences. Due to overhead, most protocols that carry text will use up a portion of the 200 bytes. Assuming (conservatively) there is 15% overhead, this leaves approximately 170 bytes of data that can be transferred. By using the available 170 bytes efficiently, it is possible to reduce both the load on transmission systems and networks and the costs of transmitting data. It is desirable to utilize the limited data links in a manner that increases the richness of communications by conveying more information in the same bandwidth, while reducing processing overhead. It is also desirable to reduce the frequency with which data messages are transmitted and to simplify system operation by reducing the need to segment and reassemble multiple messages.

Compression algorithms for reducing bandwidth consumption by data transmitted over limited data links are known in the art, but are limited in effectiveness. A typical compression ratio for text is typically only about 15%, which is hardly worth the embedded processing and memory costs. Algorithms that achieve higher than 15% compression ratio typically rely upon large internal or external dictionaries that replace words with shorter placeholders or symbols.

While compression algorithms can be effective on text or sources that are not dense with binary information, but are less effective for other applications. For example, if bitmapped information is transmitted over a link, and each bit conveys a meaning (e.g., a pixel in an image), compression techniques are limited in reducing bandwidth consumption. Referencing a large dictionary is a viable option if the computing platform has vast resources and fast network connectivity, such as with a desktop personal computer. However, referencing a large dictionary places high demands on the communication system's resources (e.g., memory) and can reduce overall performance in an embedded or mobile platform.

The Backus-Naur Form ("BNF") technique, often referred to as a "metasyntax" or "metalanguage", is well known in the fields of computer languages and programming, and is a form of notation and syntactical method that involves notating, assembling, and disassembling of languages. Extended BNF ("EBNF") has emerged as an ISO standard. Similarly, Lempel-Ziv-Welch ("LZW") is a data compression technique known in the art, frequently used for GIF graphics file formatting, one of the standard graphic formats used on the World Wide Web. However, such concepts deal inherently with compressing data at a source with decompression or storage done at the destination. Both endpoints must implement compression/decompression algorithms.

Certain advanced compression technologies focus on a particular language (e.g., English) and implement an internal dictionary or rely upon an external dictionary and perform word replacement. For example, the European Computer Manufacturers Association (ECMA) has published a standard of lossless data compression, known as Data Compression according to Lempel and Ziv (DCLZ). The ECMA protocol essentially builds a dictionary based upon the candidate target compression text by replacing redundant sequences with references placed into the dictionary. The ECMA protocol can be useful for compressing text; however, the concept of using string replacements is not effective where there is little repetition of byte sequences within a data stream.

There remains a need to efficiently and flexibly convey rich information over a limited data link, wherein the sender and/or receiver are restricted in terms of the memory and performance available for sending/receiving data over the limited data link. Pure compression systems are not up to the task. What is needed is an alternative method and system that facilitates communication of data over a limited data link between an in-vehicle user and a remote services resource (e.g., a response center).

The communication system for conveying data is preferably sufficiently flexible and adaptable to the language, symbolic, and cues utilized by a vehicle telematics system. For example, if the system does not have the desired symbol in its knowledge base, the system can be configured to be flexible enough to switch from the default method of transmitting information (e.g., predetermined identifiers, symbols or tokens in a dictionary) to a free-symbol mode. The system can be configured to be able to convey spoken and written information, as well as other symbolic representations (e.g., haptic cues). The system is preferably not hard-tied to any one language, but instead is able to toggle between language and symbolic sets. The system can employ a protocol that is flexible enough to mix and match token sizes. The system can allow for optimization of length of symbol identifiers rather than being restricted to fixed-length identifiers. Such a communication system can be used to supplement or enhance the performance of vehicle navigation systems, which allow users to determine a route from a start point to a destination point. Navigation systems having capabilities for determining the geographic position of a reference point are also well known in the art, such as Global Positioning Systems (GPS) or self-contained systems having distance and bearing sensors.

Accordingly, it would be very desirable to provide a system and method for communicating vehicle-relevant data over low bandwidth or limited data links that overcomes the above-described shortcomings of the prior art while retaining their advantages.

### SUMMARY OF THE INVENTION

The present invention addresses the shortcomings of the prior art systems and methods. In particular, the present invention is directed to a method and system for communicating messages over narrow bandwidth data links by converting the messages into protocol streams that comprise message tokens.

In accordance with one aspect of the embodiments described herein, there is provided a method and system for communicating a message over a data link. The method generally involves receiving a message that comprises one or more message objects, and referencing at least one dictionary to identify those message objects for which translations to the at least one dictionary tokens are available. The method further comprises converting each identified message object into a message token, and associating each non-identified message object with a free symbol indicator to generate a free symbol segment. The message tokens and the free symbol segments are then concatenated to generate a protocol stream that is sent over the narrow bandwidth data link to a receiver unit or location.

In accordance with another aspect of the embodiments described herein, there is provided a method and system for recovering a message received over a data link. The method generally involves receiving a protocol stream that comprises a dictionary identifier, message tokens, and at least one free symbol. The method further comprises verifying that each dictionary identified by the dictionary identifier is accessible, and selecting each dictionary identified by the dictionary identifier. Each selected dictionary is referenced to translate the message tokens into message objects. The method also comprises reassembling the message from the message objects and the at least one free symbol.

A more complete understanding of the disclosed bandwidth conservation system and method will be afforded to those skilled in the art, as well as a realization of additional advantages and objects thereof, by a consideration of the following detailed description of the preferred embodiment. Reference will be made to the appended sheets of drawings which will first be described briefly.

### BRIEF DESCRIPTION OF THE DRAWINGS

Fig. 1a is a schematic diagram of a first embodiment of a communication system pursuant to aspects of the invention;
Fig. 1b is a schematic diagram of a broadcast communication network;
Fig. 1c is a schematic diagram of a navigation device in communication with a mobile unit;
Fig. 2 is a schematic diagram of an alternate embodiment of a communication system;
Fig. 3 illustrates an embodiment of a token/symbolic dictionary and some of the types of data contained by the dictionary;
Fig. 4 is a schematic diagram of an embodiment of a data communication system wherein the sender and receiver each comprise the same token/symbolic dictionaries;
Fig. 5a is a schematic diagram of an embodiment of a protocol stream for both predetermined identifiers and free symbols; and
Fig. 5b illustrates an exemplary protocol stream that comprises free symbols.

### DETAILED DESCRIPTION OF THE PREFERRED EMBODIMENT

The present invention is directed to a system and method for sending data over a low bandwidth data communications link. In particular, the present invention is directed to a system and method for utilizing token or symbolic dictionaries at the transmitting and receiving ends of the low bandwidth data link to facilitate the efficient transfer of data over the data link, sometimes referred to as a data pipe or channel. In the detailed description that follows, like element numerals are used to describe like elements illustrated in one or more of the figures.

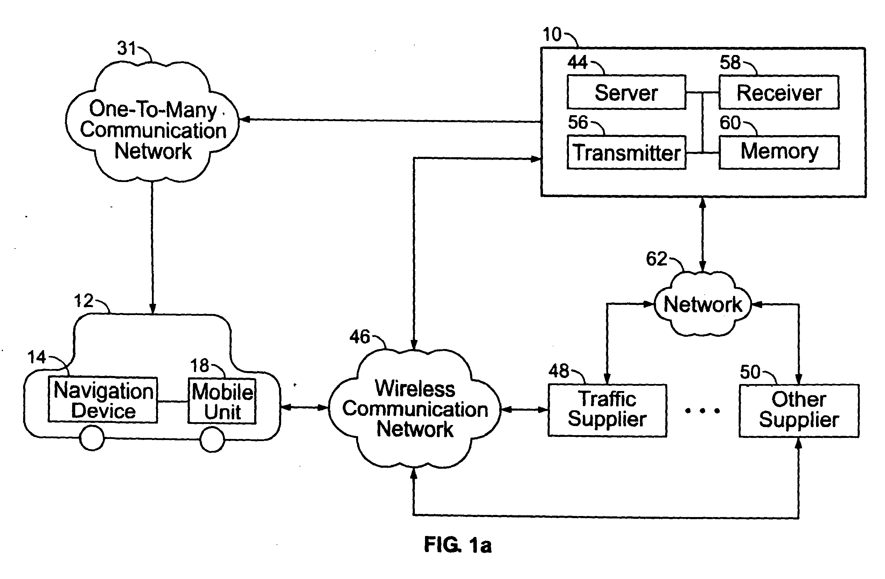

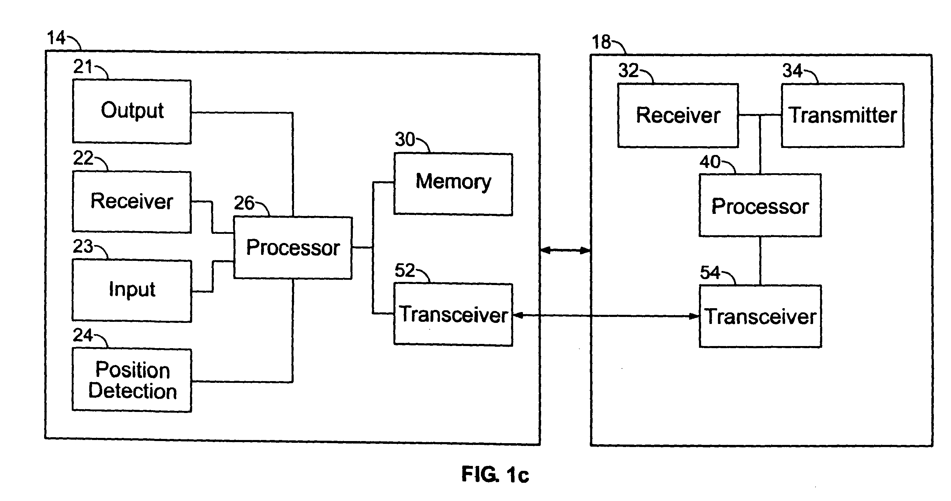

With reference to Fig. 1a, there is provided a first embodiment of a system for the exchange of information between a remote location 10 and a vehicle 12 pursuant to aspects of the invention. The vehicle 12 includes a navigation device 14. Referring now also to Fig. 1c, the navigation device 14 may include an output unit 21, a receiver unit 22, an input unit 23, a position detection unit 24, a navigation memory unit 30, a navigation processor unit 26, and an RF transceiver unit 52 that are all in electrical communication with one another. The navigation memory unit 30 includes at least a portion of a user profile and in some embodiments may include the entire user profile. In addition, the navigation memory unit 30 includes a road map database portion and, in some embodiments, includes a disk reading unit for reading road map information not built into the navigation device 14. As is provided in greater detail below, the user profile and/or the road map database stored in the memory 30 may be updated in the vehicle by way of the input unit 23, which can include at least one of a keyboard, a touch sensitive display, and a microphone. The user profile and/or the road map database may also be updated by way of information received through the receiver unit 22 and/or the RF transceiver unit 52.

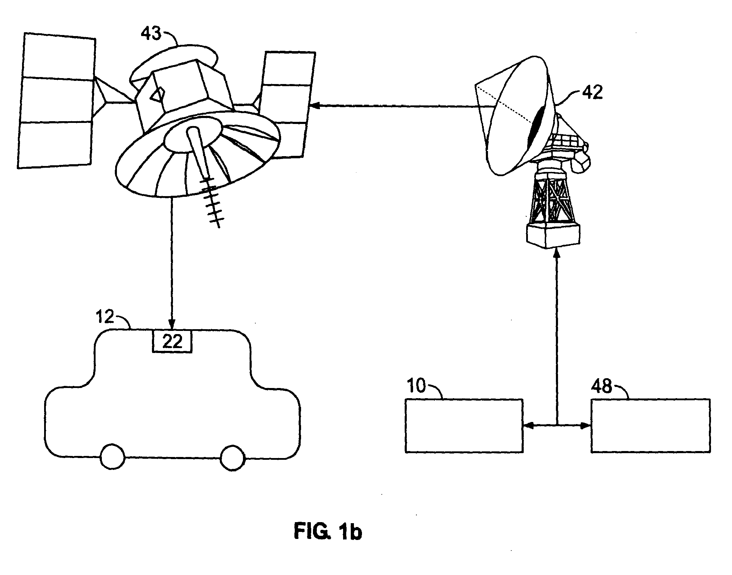

The receiver unit 22 receives information from the remote location 10 and, in one embodiment, is in communication with the remote location by way of a one-to-many communication system. One-to-many communication systems include systems that can send information from one source to a plurality of receivers, such as a broadcast network 31. Broadcast networks include television, radio, and satellite networks. Referring now to Fig. 1b, in one embodiment, the broadcast network 31 is the XM Radio satellite network 40, which comprises broadcast towers 42, satellite servers (not shown), and satellites 43. The broadcast towers 42 transmit information to the satellites 43, which bounce the information back down to the receiver unit 22 of the navigation device 14.

Referring now back to Fig. 1c, the information received by the receiver 22 may be processed by the navigation processor unit 26. The processed information may then be displayed by way of the output unit 21, which includes at least one of a display and a speaker. In one embodiment, the receiver unit 22, the navigation processor unit 26 and the output unit 21 are provided access to only subsets of the received broadcast information based on user preferences and/or traffic information demands. The user preferences, as well as user identity information and traffic-related information, can be part of the user profile.

The position detection unit 24 may include a GPS receiver that communicates with a plurality of GPS satellites (separate from the XM satellites) to determine the position of the vehicle 12. For example, the GPS receiver searches for and collects GPS information (or signals) broadcast from four or more GPS satellites that are in view of the GPS receiver. Next, using the time interval between the broadcast time and reception time of each broadcast signal, the GPS receiver calculates the distance between the GPS receiver and each of the four or more GPS satellites. These distance measurements, along with the position and time information received in the broadcast signals, allow the GPS receiver to calculate the geographic position of the vehicle 12.

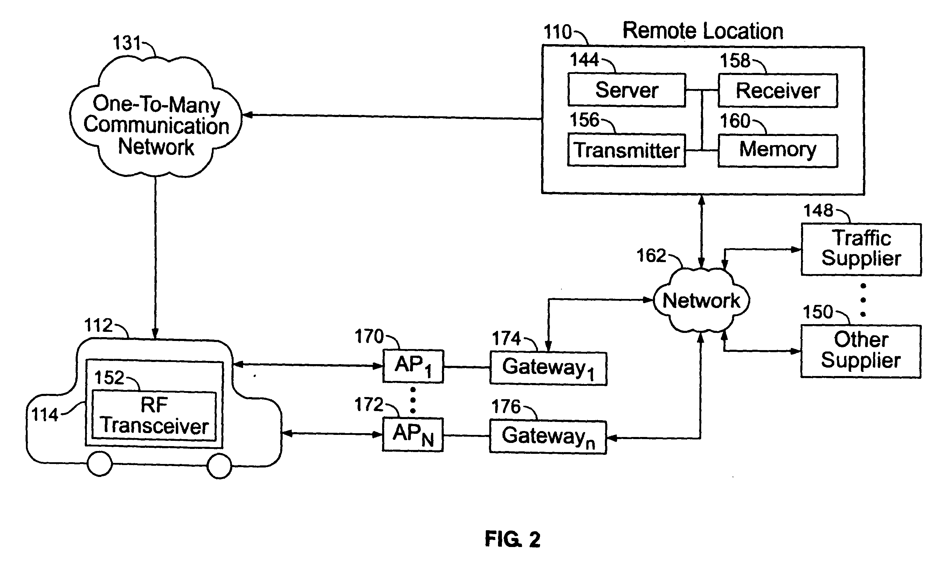

In the embodiment shown in Fig. 1a, the mobile unit 18 is used to receive and transmit information from and to the remote location 10; and, in an alternate embodiment shown in Fig. 2, an RF transceiver 152 is used to receive and transmit information from and to the remote location 110. The mobile unit 18 may be a wireless phone or any other device that communicates with other devices by way of the wireless communication network 46. As shown in Fig. 1c, in one embodiment, the mobile unit 18 includes a wireless receiver 32, a wireless transmitter 34, a mobile unit processor 40, and an RF transceiver unit 54 that are in communication with one another. The mobile unit 18 is in two-way communication with the remote location 10 by way of the receiver 32, the transmitter 34, and the wireless communication network 46, which comprises numerous base stations. In one embodiment, information is transmitted from or to the vehicle or remote location over a high bandwidth packet data (e.g., GPRS, EDGE, 1xRTT, 1xEV, HSDPA, Flash-OFDM, etc.) channel of the wireless communication network 46. If the high bandwidth channel is unavailable, a low bandwidth DTMF channel can be used. The receiver 32 receives information from the remote location 10, and the transmitter 34 transmits information to the remote location 10. In other embodiments, the transmitter 34 also transmits information to suppliers of traffic or other information 48, 50.

In one embodiment, the information received from and transmitted to the remote location 10 by way of the mobile unit 18 is accessed by the user through the navigation device 14, which is in communication with the mobile unit 18. The mobile unit 18 may be embedded in the vehicle 12 and be in communication with the navigation device 14 by, for example, a cable (not shown).

In another embodiment, the navigation device 14 and mobile unit 18 are in communication with one another by way of RF transceiver units 54 and 52. Both the navigation device 14 and the mobile unit 18 include RF transceiver units 52, 54, which, in one embodiment, comply with the Bluetooth® wireless data communication format or the like. The RF transceiver units 52, 54 allow the navigation device 14 and the mobile unit 18 to communicate with one another. In other embodiments not shown, the receiver 32 and transmitter 14 of the mobile unit 18 and the receiver unit 20 of the navigation device 14 allow the navigation device 14 and mobile unit 18 to communicate with one another. In yet other embodiments, there may be an RF transceiver that is separate from the navigation device 14 and the mobile unit 18 and that allows the navigation device 14 and mobile unit 18 to communicate with one another.

In the alternate embodiment shown in Fig. 2, the navigation device 114 transmits and receives information to and from the remote location 110 by way of the RF transceiver 152, access points 170, 172, and gateways 174, 176 that are in communication with the network 162. In one embodiment, the RF transceiver 152 and the access points 170, 172 are compliant with the IEEE 802.11 specification, and such transceivers and access points include Wi-Fi® - certified equipment. The access points 170, 172 are typically in communication with the gateways 174, 176 by way of a cable, and the gateways are in communication with the remote location 110 by way of the network 162. The access points 170, 172 are in communication with the RF transceiver 152 and have a limited range over which they can communicate with the RF transceiver 152. Thus, it is preferable that there be numerous access points 170, 172 positioned so that the distance between the access points and the areas through which a vehicle 12 might pass is less than or equal to the limited range of the access points. When the access points 170, 172 are so positioned, the RF transceiver 152 effectively exchanges information with the access points 170, 172 and, thus, the remote location 110.

Note that in the alternate embodiment of Fig. 2, the navigation device 114 also includes input and output units, a receiver unit, a memory unit, and a processor unit, none of which are shown. The components of the alternate navigation device embodiment 114 have the same functionality as do the corresponding components of the navigation device 14 of the first embodiment.

Referring now to Figs. 1a and 2, the remote location 10, 110 includes a remote server 44, 144, a remote transmitter 56, 156 and receiver 58, 158, and a remote memory 60, 160 that are in communication with one another. As provided above, in the first embodiment, the remote transmitter and receiver 56, 58 communicate with the navigation device 14 and mobile unit 100 by way of the broadcast 31 and wireless 46 communication networks, respectively. In the alternate embodiment, the remote transmitter and receiver 156, 158 communicate with the navigation device 114, including the RF transceiver 152, by way of the broadcast communication network 131 and a network 162. The remote location 10, 110 is also in communication with suppliers of traffic and/or other information 48, 50, 148, 150 such as government traffic information suppliers, private traffic information suppliers, and users of other vehicles, by way of the network 62, 162.

In both the first and alternate embodiments shown in Figs. 1a-1c and 2, the network 62, 162 is typically a wide area network (WAN) such as the Internet. In other embodiments, some of the information suppliers 48, 50, 148, 150, such as the government and private traffic information suppliers, may be in communication with the remote location 10, 110 by way of a local area network (LAN), while other information providers 48, 50, 148, 150 such as the vehicle users, are in communication with the remote location by way of the Internet. In yet other embodiments, the RF transceiver 152 is in communication with the remote location 110 and/or the information providers 148, 150 by way of a network 162 that is a LAN. In these other embodiments, the LAN 162 is compliant with the IEEE 802.3 specification or is an Ethernet network.

As provided in greater detail below, the information suppliers 48, 50, 148, 150 may transmit updated user profiles and traffic-related information to the remote location 10, 110. A plurality of user profiles are in a user profile database, which, along with traffic-related information, is stored in the remote memory 60, 160. The updated user profiles and new traffic-related information are transmitted from the remote location 10, 110 to the navigation device 14, 114 by way of the broadcast network 31, 131. In other embodiments, the new traffic-related information and updated user profiles may be transmitted to the vehicles 12, 112 by way of the wireless network 46 or the network 162. At the vehicle, the user profile stored in the memory 30 of the navigation device 14 is updated, and the vehicle-related information is made accessible to the user by way of the output unit 26 of the navigation device 14. In other embodiments, the information providers may communicate directly with the mobile unit 18 or RF transceiver 152 by way of the wireless communication network 46 or the network 162.

As explained above, in accordance with one aspect of the embodiments described herein, there is provided a system and method for transmitting data over a limited data link between a sender/transmitter and a receiver, wherein the transmitter and receiver each have identical copies of one or more token/symbol dictionaries. The transmitter and receiver typically each hold at least one copy of identical fixed-length dictionaries. For example, in one embodiment, the fixed-length dictionaries each comprise about 300 words or tokens. In order for the transmitter and receiver to communicate and understand one another, the transmitter and receiver must hold the same dictionary. If the receiver and sender want to communicate emergency information, they will each refer to their "emergency" dictionary. Alternatively, under an extension of the protocol, the sender can download one or more new dictionaries to the receiver.

In one embodiment, the transmitter/sender is a provider of remote services while the receiver is an in-vehicle client device, such as a telematics device. In another embodiment, the vehicle comprises the transmitter while the remote location comprises the receiver. In yet another embodiment, the vehicle comprises a first transmitter and a first receiver, while the remote location comprises a second transmitter and a second receiver.

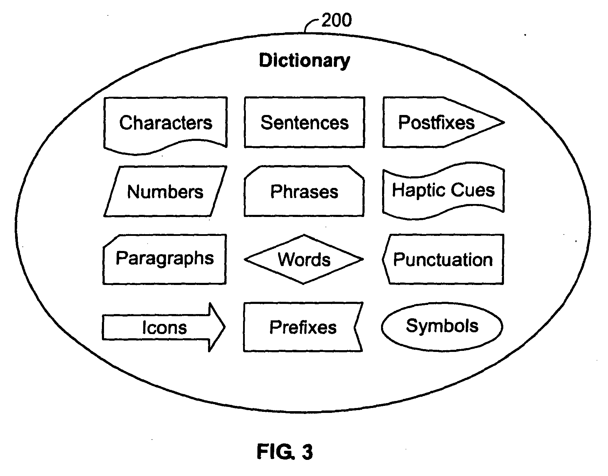

As explained above, each dictionary will contain tokens or symbols for efficient, low-bandwidth communication between a sender and a receiver. The dictionary can contain a set of English words and basic punctuation. However, dictionary entries could symbolize almost anything as long as there is an agreement or understanding between the end parties as to what reference an entry represents. Each dictionary's content can be homogeneous or can comprise heterogeneous collections ("objects") depending on the particular application. As shown in Fig. 3, the dictionary 200 can comprise characters, sentences, postfixes, numbers, phrases, haptic cues, paragraphs, words, punctuation, icons, prefixes, symbols, etc.

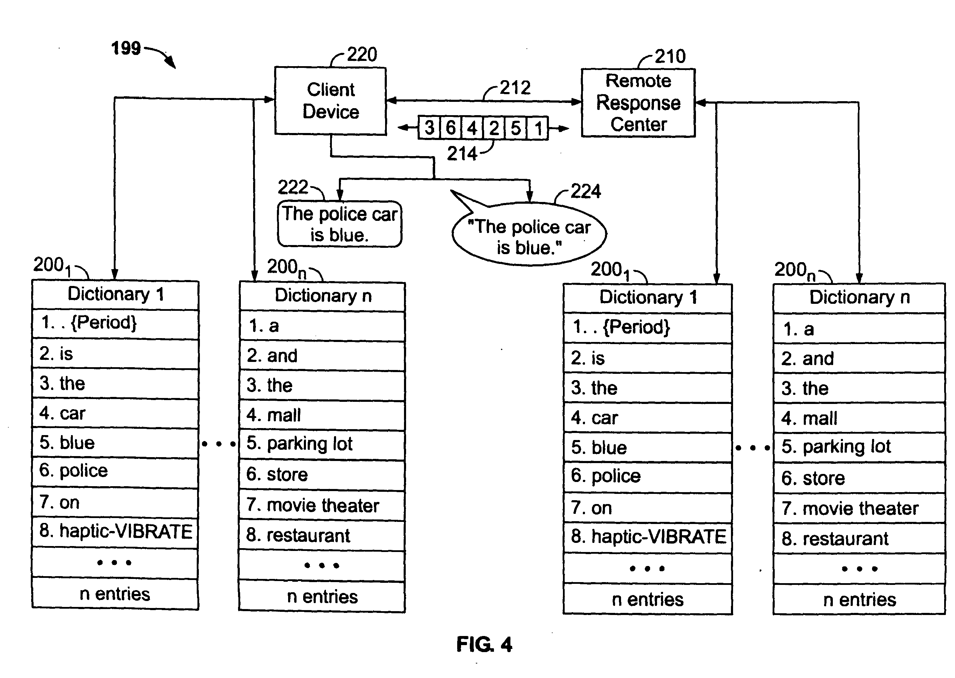

With reference to Fig. 4, in one embodiment, the data transmission system 199 comprises a remote response center 210 and a client device 220 (e.g., a telematics device in a car) that are in communication with each other via a communication or data link 212. The data link 212 typically has bandwidth, packet size, and usage restrictions. In one embodiment, the data link 212 is a narrowband transmission link, channel, pipe, or the like, over a wireless network. The remote response center 210 and the client device 220 typically have one or more dictionaries, each with a plurality of words and symbols, according to the needs or demands of a particular application. For example, the center 210 and the device 220 each comprise n different dictionaries (200₁ through 200ₙ). In one embodiment, the transmitter unit comprises a remote response center or the like. In another embodiment, the receiver unit comprises a vehicle onboard computer, client device, or the like.

The dictionaries (200₁ through 200ₙ) are typically in memory units/devices that are in communication with the transmitter/receivers units. The transmitter/sender unit and the receiver unit have identical copies of the dictionaries (200₁ through 200ₙ). The dictionaries are typically relatively small or limited in size. This can be achieved by utilizing dictionaries that are application or task specific, thereby avoiding the use of unnecessarily large dictionaries that fill memory units/devices with content that is not needed. The dictionaries can be modular in nature to facilitate efficient transfer of dictionary data to or from the memory units that are in communication with the transmitter/receivers units. In one exemplary embodiment, the data transmission system 199 comprises modular, relatively small dictionaries (200₁ through 200ₙ) that make it easier to add, change, or replace the dictionaries (200₁ through 200ₙ) according to the application or task at hand.

In producing the translated version of the message to be sent over the limited data link, the sender typically assembles a protocol stream containing a chain of identifiers that represent the dictionary entries or tokens to convey. Other information can be encoded, such as protocol mode, length information, characterization of token lengths, and information to the receiver regarding which dictionary to use in translating the received tokens/symbols. Upon receiving the stream of tokens, the receiver will refer to the correct dictionary and translate the stream into the correct sequence of objects. The receiver can then use these objects to convey richer information to the user that otherwise would not have been possible.

With continued reference to the embodiment of Fig. 4, the sender/transmitter unit or location (e.g., remote response center 210) is in electronic communication with a memory unit that stores one or more dictionaries (e.g., 200₁ through 200ₙ). The transmitter unit receives the message to be communicated (e.g., "The police car is blue."), wherein each word and punctuation mark is a message object. The transmitter unit references at least one dictionary to identify those message objects for which translation to dictionary tokens or identifiers are available, and converts each identified message object into a message token. For example, the center 210 retrieves the appropriate dictionary based upon service needs, user input, etc., and assembles a protocol stream 214 containing multiple identifiers (e.g., 3, 6, 4, 2, 5, and 1). The protocol stream 214, which comprises the IDs of dictionary tokens, is transmitted to one or more receiver units or devices.

The receiver unit (e.g., client device 220) is typically in wireless communication with the transmitter unit or location (e.g., remote response center 210). More specifically, in the present embodiment, the receiver and transmitter units are in RF wireless communication with each other over a limited data link having narrow bandwidth. The receiver unit typically receives the protocol stream, verifies that the memory unit comprises each dictionary identified by the dictionary identifier, and then selects each dictionary identified by the dictionary identifier. The receiver unit references each selected dictionary to translate the message tokens into message objects, and reassembles the message from the message objects and the at least one free symbol, explained in further detail below. For example, upon receiving the protocol stream 214, the device 220 refers to the correct dictionary (i.e., the same dictionary utilized by the center 210) and translates the protocol stream into objects (e.g., 3 = "the"; 6 = "police"; 4 = "car"; 2 = "is"; 5 = "blue"; 1 = "."). In other words, the phrase is reassembled at the receiving client device 220 and conveyed to the user. The reassembled phrase (e.g., "the police car is blue.") can be conveyed to the user via a display device 222 , a speaker 224, or the like, or combinations thereof.

The transmitting and receiving roles of the remote response center 210 and the client device 220, respectively, can be reversed (i.e., the device 220 can transmit the protocol stream 214 to the center 210) depending on the particular application. Also, the device 220 and center 210 can utilize a plurality of dictionaries to convey protocol streams 214 to each other.

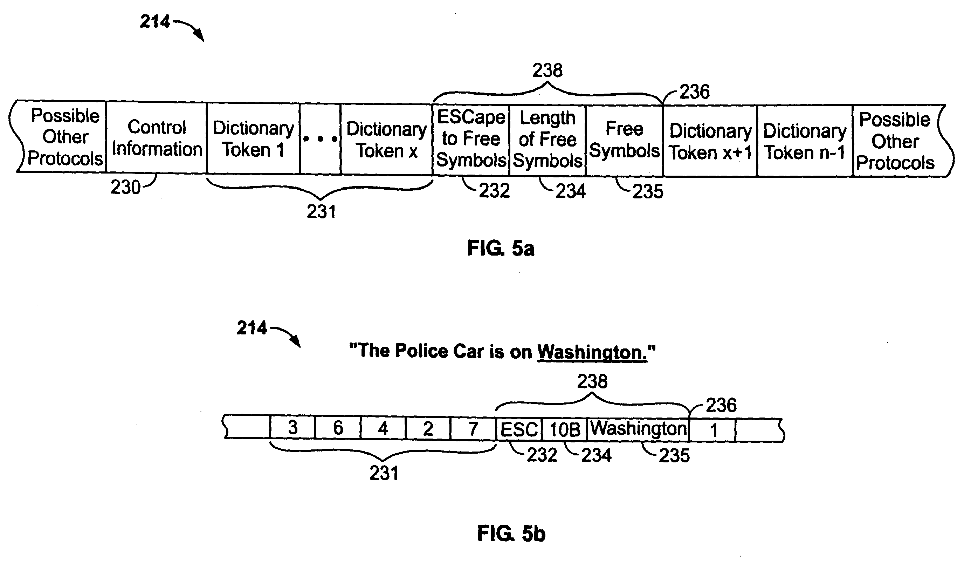

The dictionary 200 utilized by the sender and receiver may not always contain a token for the object that the sender wishes to convey. In one embodiment, the protocol allows escapement into free-symbol mode, wherein an encoding (e.g., ASCII characters) can be used to convey items that are not in the dictionary 200. As shown in Figs. 5a and 5b, dictionary symbols can be mixed with free symbols - words, phrases, etc. that are not located in the limited dictionaries - when the dictionary 200 does not contain the desired token(s). For example, suppose the center 210 intends to send the message "the police car is on Washington" to a user near the device 220. All of the words in this sentence are located in one of the limited dictionaries except for "Washington." The transmitter assembles a protocol stream 214 containing multiple identifiers (e.g., 36427) and a free symbol (e.g., "Washington").

With reference to Figs. 5a and 5b, in one exemplary embodiment, the protocol stream 214 comprises a control information area or segment 230 that can include information regarding the protocol mode, which dictionary to use, token lengths, etc. The stream 214 further comprises an identifier segment 231, which is made up of one or more dictionary tokens. The stream 214 further comprises an escape marker or free symbol indicator 232 indicating that a free symbol area 235 will follow. The escape marker 232 is followed by an area 234 that includes information regarding the length of the proceeding free symbol area 235. Marker 236 indicates where the free symbol area 235 ends. The marker 236 also indicates the beginning of another identifier segment comprising one or more dictionary tokens. Upon receiving the protocol stream 214, the receiver refers to the correct dictionary (based on the information in area 230) and translates the protocol stream into objects (e.g., 3 = "the"; 6 = "police"; 4 = "car"; 2 = "is"; 7 = "on"; free symbol = "Washington"). The phrase "the police car is on Washington" is reassembled at the receiver and conveyed to the user.

The transmitter typically converts each identified message object into a message token, and also associates each non-identified message object with a free symbol indicator to generate a free symbol segment from each non-identified message object. In one embodiment, the transmitter associates each non-identified message object with the free symbol indicator by prefixing each non-identified message with the free symbol indicator. The transmitter then concatenates the message tokens and the free symbol segments to generate the protocol stream that is sent over the narrow bandwidth data link to a receiver.

Upon receiving the protocol stream, the receiver typically verifies that the memory unit it is in communication with comprises each dictionary identified by the dictionary identifier, and then selects each dictionary identified by the dictionary identifier. The receiver references each selected dictionary to translate the message tokens into message objects, and reassembles the message from the message objects and any free symbols, as explained above. The receiver unit preferably alerts the user if it is not able to access one or more dictionaries identified by the protocol stream's dictionary identifier and/or obtains copies of the missing dictionaries to be stored in a local or internal memory.

Having thus described a preferred embodiment of a method and system for traffic management between a vehicle and a remote location, it should be apparent to those skilled in the art that certain advantages of the within system have been achieved. It should also be appreciated that various modifications, adaptations, and alternative embodiments thereof may be made within the scope and spirit of the present invention. For example, the use of broadcast communication networks has been illustrated, but it should be apparent that many of the inventive concepts described above would be equally applicable to the use of other non-broadcast communication networks.

## Claims

1. A system for communicating over a data link, comprising:
a transmitter unit; and
a memory unit (30) in communication with the transmitter unit, the memory unit (30) comprising one or more dictionaries;
wherein the transmitter unit is adapted to:
receive a message to be communicated, the message comprising at least one message object;
identify any of the at least one message objects having a corresponding translation in a first dictionary;
convert each identified message object into a message token;
associate each non-identified message object with a free symbol indicator (232) to generate a free symbol segment;
concatenate the message tokens and the free symbol segments to generate a protocol stream; and
send the protocol stream over the data link.

2. The system as recited in Claim 1, wherein the transmitter unit is adapted to associate each non-identified message object with the free symbol indicator (232) by prefixing each non-identified message with the free symbol indicator (232) .

3. The system as recited in any of the preceding claims, wherein the transmitter unit is adapted to associate a dictionary identifier with the protocol stream, the dictionary identifier identifying the first dictionary used in generating the protocol stream.

4. The system as recited in any of the preceding claims, wherein the transmitter unit is adapted to identify any of the at least one message objects having a corresponding translation in a second dictionary.

5. The system as recited in any of the preceding claims, wherein the transmitter unit is adapted to associate a dictionary identifier with the protocol stream, the dictionary identifier identifying the first dictionary and the second dictionary used in generating the protocol stream.

6. The system as recited in any of the preceding claims, wherein the first dictionary has tokens for message object types selected from the group consisting of characters, sentences, postfixes, numbers, phrases, haptic cues, paragraphs, words, punctuation, icons, prefixes, and symbols.

7. A method for communicating over a data link, comprising:
receiving a message to be communicated, the message comprising at least one message object;
identifying any of the at least one message objects having a corresponding translation in a first dictionary;
converting each identified message object into a message token;
associating each non-identified message object with a free symbol indicator (232) to generate a free symbol segment;
concatenating the message tokens and the free symbol segments to generate a protocol stream; and
sending the protocol stream over the data link.

8. The method of any of the preceding claims, wherein associating each non-identified message with the free symbol indicator (232) comprises prefixing each non-identified message with the free symbol indicator (232).

9. The method of any of the preceding claims, further comprising associating a dictionary identifier with the protocol stream, wherein the dictionary identifier identifies the first dictionary used in generating the protocol stream.

10. The method of any of the preceding claims, further comprising identifying any of the at least one message objects having a corresponding translation in a second dictionary.

11. The method of any of the preceding claims, further comprising associating a dictionary identifier with the protocol stream, wherein the dictionary identifier identifies the first dictionary and the second dictionary used in generating the protocol stream.

12. A system for recovering a message received over a data link, comprising:
a receiver unit (22); and
a memory unit (30) in communication with the receiver unit (22), the memory unit (30) comprising one or more dictionaries;
wherein the receiver unit (22) is adapted to:
receive a protocol stream that comprises a dictionary identifier, message tokens, and at least one free symbol;
select the a dictionary identified by the dictionary identifier;
reference the first dictionary to translate the message tokens into message objects; and
reassemble the message from the message objects and the at least one free symbol.

13. The system as recited in any of the preceding claims, wherein the receiver unit (22) is adapted to verify that the memory unit (30) comprises the first dictionary identified by the dictionary identifier.

14. The system as recited in any of the preceding claims, wherein the receiver unit (22) is adapted to alert a user if the memory unit (30) is missing the first dictionary.

15. The system as recited in any of the preceding claims, wherein the receiver unit (22) is adapted to access the first dictionary and copy the first dictionary into the memory unit.

16. The system as recited in any of the preceding claims, wherein the receiver unit (22) is adapted to:
select a second dictionary identified by the dictionary identifier; and
reference the second dictionary to translate the message tokens into message objects.

17. The system as recited in any of the preceding claims, wherein the receiver unit (22) is adapted to verify that the memory unit (30) comprises the second dictionary identified by the dictionary identifier.

18. The system as recited in any of the preceding claims, wherein the receiver unit (22) is adapted to display the reassembled message for a user.

19. A method for recovering a message received over a data link, comprising:
receiving a protocol stream that comprises a dictionary identifier, message tokens, and at least one free symbol;
selecting a dictionary identified by the dictionary identifier;
referencing the selected dictionary to translate the message tokens into message objects; and
reassembling the message from the message objects and the at least one free symbol.

20. The method of any of the preceding claims, further comprising verifying that the dictionary identified by the dictionary identifier is accessible.

21. The method of any of the preceding claims, further comprising alerting a user if the dictionary identified by the dictionary identifier is not accessible.

22. The method of any of the preceding claims, further comprising obtaining a copy of the identified dictionary.

23. The method of any of the preceding claims, further comprising displaying the reassembled message.
